# EUROPEAN PATENT APPLICATION

(11) **EP 4 764 520 A1**
(43) Date of publication of application: **24.06.2026**
(21) Application number: 25226792.7
(22) Date of filing: 23.12.2025
(51) Int. Cl.: G01R 31/34

(54) **CURRENT TRANSFORMER DETERMINING AN OPERATING STATE**

(30) Priority: 23.12.2024 US 202463737857 P
(71) Applicant: Senva Inc., Beaverton, OR 97006 (US)
(72) Inventor: LIAKHOVITCH, Anton, Beavertown (US); PAULL, Dalton, Scappoose (US)
(74) Representative: St Clair Jones, Gregory Arthur Langley

(57) **Abstract**

A current transformer includes a current sensor sensing a current of a conductor signal transmitted along a conductor and outputting a current signal based on the current and an electronic assembly connected to the current sensor and receiving the current signal from the current sensor. The electronic assembly determines an operating state of a powered device to which the conductor feeds the conductor signal based on the current signal. The electronic assembly is tuned to use the current signal of the current in a frequency range greater than or equal to 100Hz to determine the operating state.

## Description

### FIELD OF THE INVENTION

The present invention relates to a sensor and, more particularly, to a current transformer disposed on a conductor and determining an operating state of a powered device to which the conductor is connected.

### BACKGROUND

A current transformer is often used to determine whether a motor is running. The current transformer is positioned on a conductor that supplies power to the motor and, based on a detected current flowing through the conductor, the current transformer determines whether the motor is on or off.

Current transformers are commonly used with induction motors. Induction motors have a significant difference between a quiescent current and a low current when the motor is running at low speed; current transformers are able to reliably determine, based on this difference, when the induction motor is running and when the induction motor is off. Electronically commutated (ECM) motors, however, are increasingly common and have a low run current and a high quiescent current, lessening the difference in current between on and off states and making current transformer detection of ECM motors more difficult and less reliable.

Further, existing current transformers are commonly sensitive to current in the conductor at a frequency of around 50 or 60Hz. Although this frequency range is effective for induction motors, the current in ECM motors is commonly in a higher harmonic range. Existing current transformers thus cannot reliably detect an operating state of an ECM motor.

### SUMMARY

A current transformer includes a current sensor sensing a current of a conductor signal transmitted along a conductor and outputting a current signal based on the current and an electronic assembly connected to the current sensor and receiving the current signal from the current sensor. The electronic assembly determines an operating state of a powered device to which the conductor feeds the conductor signal based on the current signal. The electronic assembly is tuned to use the current signal of the current in a frequency range greater than or equal to 100Hz to determine the operating state.

### BRIEF DESCRIPTION OF THE DRAWINGS

The invention will now be described by way of example with reference to the accompanying Figures, of which:
Figure 1 is a perspective view of a current transformer according to an embodiment;
Figure 2 is a side view of the current transformer of Figure 1 with a portion of a housing removed to show interior components;
Figure 3 is a block diagram of a sensor assembly according to an embodiment;
Figure 4 is a flowchart of a process of determining an operating state of a powered device of the sensor assembly; and
Figure 5 is a graph of frequency vs. current for the powered device.

### DETAILED DESCRIPTION OF THE EMBODIMENT(S)

Exemplary embodiments of the present disclosure will be described hereinafter in detail with reference to the attached drawings, wherein like reference numerals refer to like elements. The present disclosure may, however, be embodied in many different forms and should not be construed as being limited to the embodiments set forth herein; rather, these embodiments are provided so that the present disclosure will convey the concept of the disclosure to those skilled in the art. In addition, in the following detailed description, for purposes of explanation, numerous specific details are set forth to provide a thorough understanding of the disclosed embodiments. However, it is apparent that one or more embodiments may also be implemented without these specific details.

Throughout the drawings, only one of a plurality of identical elements may be labeled in a figure for clarity of the drawings, but the detailed description of the element herein applies equally to each of the identically appearing elements in the figure.

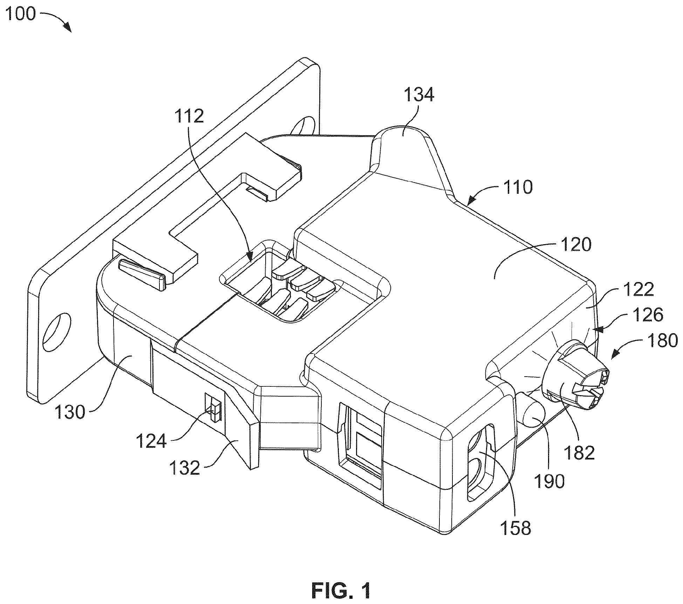

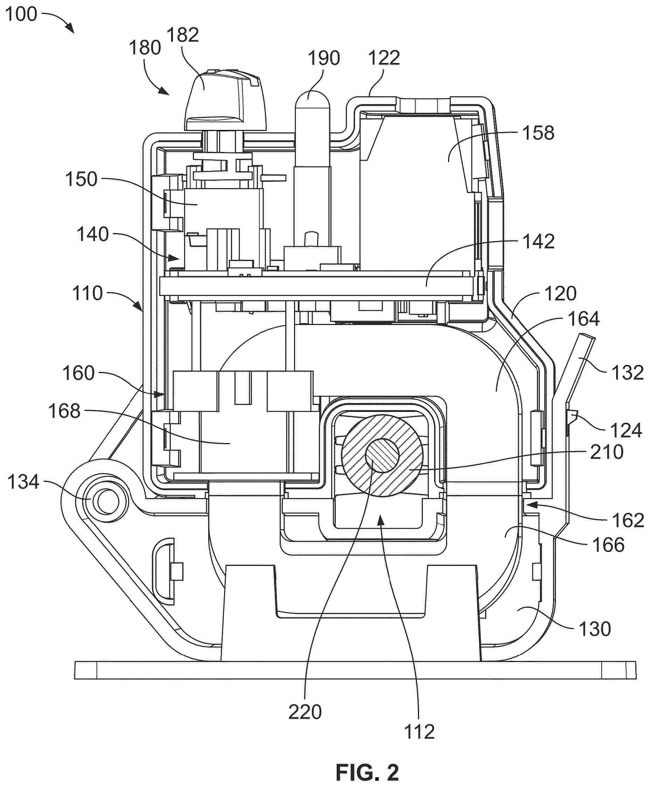

A current transformer 100 according to an embodiment is shown in Figures 1 and 2. The current transformer 100 includes a housing 110, an electronic assembly 140 disposed in the housing 110, and a current sensor 160 disposed in the housing 110 and connected to the electronic assembly 140.

The housing 110, as shown in Figures 1 and 2, has a wire receiving opening 112 extending through the housing 110. The housing 110, in the shown embodiment, is formed of a first portion 120 and a second portion 130 that are attached together around a hinge 134. The first portion 120 and the second portion 130 each define a part of the wire receiving opening 112. The housing 110 is formed from a plastic material, such as nylon or acrylonitrile butadiene styrene (ABS). In the shown embodiment, each of the first portion 120 and the second portion 130 is monolithically formed in a single piece from the plastic material of the housing 110.

The first portion 120, as shown in Figures 1 and 2, has an outer surface 122. On a portion of the outer surface 122, the first portion 120 has a plurality of markers 126. In the shown embodiment, the markers 126 are hash marks positioned in an approximately circular arrangement. In other embodiments, the markers 126 could be numbers or any other type of indications on the outer surface 122 that can correlate to selections made with an adjustment element 180, as described in greater detail below.

The first portion 120 and the second portion 130 are rotatable about the hinge 134 between an open position and a closed position shown in Figure 1. In the shown embodiment, the first portion 120 has a protrusion 124 extending from a side and the second portion 130 has a latch 132 that engages with the protrusion 124 to releasably secure the closed position. In other embodiments, the portions 120, 130 may be secured in the closed position by any type of mechanical securing or fastening elements.

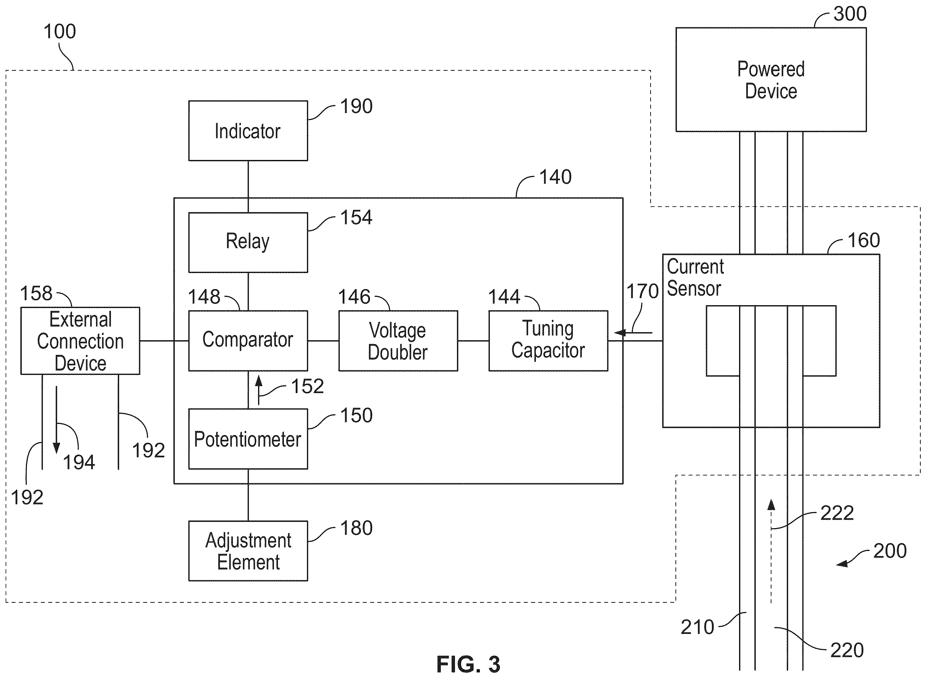

The electronic assembly 140, as shown in Figure 2, includes a printed circuit board (PCB) 142. The PCB 142 may be any type of PCB that can accommodate and connect the components described herein. As shown in Figure 3, the electronic assembly 140 has a plurality of components positioned on the PCB 142 and connected to each other by the PCB 142, including a tuning capacitor 144, a voltage doubler 146, a comparator 148, a potentiometer 150, and a relay 154.

The tuning capacitor 144, shown in Figure 3, is disposed on the PCB 142 and is connected to the current sensor 160. The tuning capacitor 144 may be any type of capacitor that can store a charge received from the current sensor 160 and is tuned to a frequency range as described below. In another embodiment, the tuning capacitor 144 may be omitted.

The voltage doubler 146, in an embodiment, is a voltage doubler and rectification circuit. The comparator 148 and the potentiometer 150 may be any type of comparators and potentiometers used in electronics that can perform the functions described herein. The relay 154, in an embodiment, is a solid-state relay, such as an N/O solid-state relay.

The current transformer 100 includes an external connection device 158, shown in Figures 1-3, that is disposed on the PCB 142 and connected to the comparator 148. The external connection device 158 may be any device capable of outputting an analog signal or a digital signal. The external connection device 158 is exposed outside of the housing 110, as shown in Figures 1 and 2, may be connectable to at least one external signal wire 192, as shown in Figure 3, for outputting the analog or digital signal. In another embodiment, the external connection device 158 can output a signal by a solid state or electromechanical dry contact relay closure. The external connection device 158 may additionally be connectable to an external power wire and may receive power from the external power wire.

As shown in Figure 2, the current sensor 160 has a core 162 and a coil 168 wound around a portion of the core 162. The core 162 is formed of a magnetic, iron material and the coil 168 is formed of a conductive material, such as copper. The core 162 produces a magnetic flux that depends on the current of a conductor extending through the core 162. The magnetic flux produces a proportional current in the coil 168, which can be output as a current signal 170, shown in Figure 3, to represent the current of the conductor extending through the core 162.

In the shown embodiment, the core 162 has a first section 164 and a second section 166 that is detached from the first section 164 and is movable with respect to the first section 164. The second section 166 is disposed in the second portion 130 and, in the closed position of the hinge 134, the second section 166 of the core 162 abuts the first section 164 of the core 162 as shown in Figure 2.

As shown in Figures 1-3, the current transformer 100 includes an adjustment element 180 connected to the electronic assembly 140. The adjustment element 180 is exposed on the outer surface 122 of the housing 110 and extends through the housing 110. The adjustment element 180 includes a manipulated element 182 that is connected to the potentiometer 150. In the shown embodiment, the manipulated element 182 is a knob disposed on the outer surface 122 of the housing 110 that can be rotated by a user. The potentiometer 150 generates and sends a signal to the comparator 148 based on a position of the manipulated element 182, as described in detail below. In other embodiments, the manipulated element 182 could be any type of switch, toggle, buttons, or other mechanical device accessible from the outer surface 122 of the housing 110 that allows a user to indicate a selection, and the potentiometer 150 may be any type of device that can generate an electrical signal based on the position of the manipulated element 182.

The indicator 190, as shown in Figures 1-3, is disposed on the PCB 142 and extends away from the PCB 142 and through the housing 110. The indicator 190 is visible from outside the housing 110. In an embodiment, the indicator 190 is a light emitting diode (LED) that is controllable to emit a selected color. In other embodiments, the indicator 190 can be any type of device that can be controlled to change an indication to an area outside of the housing 110, including an electrophoretic display, an LED having only binary color output, or other low power display elements.

A sensor assembly 10 according to an embodiment is shown in Figure 3 and includes the current transformer 100, a wire 200, and a powered device 300. The wire 200 is connected to the powered device 300 and supplies a conductor signal 222 to the powered device 300 to provide power to the powered device 300. The wire 200 has an insulation 210 disposed around a conductor 220; the conductor signal 222 is transmitted along the conductor 220. In various embodiments, the powered device 300 may be a constant volume fan or pump, a VFD fan or pump, or an electronically commutated motor (ECM). These exemplary applications are not limiting, however, and the current transformer 100 can be used as described herein with wires 200 attached to any other type of powered device 300 that receives power from the conductor signal 222 transmitted along the wire 200.

As shown in Figures 2 and 3, the current transformer 100 is positioned with the wire 200 extending through the core 162 of the current sensor 160. The wire 200 can extend through the wire receiving opening 112 of the housing 110.

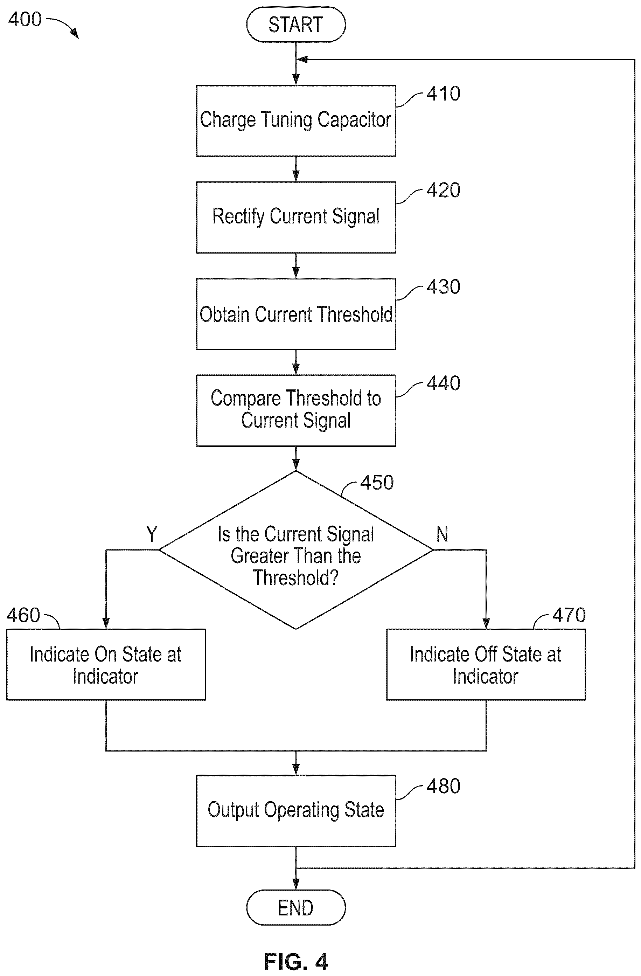

A process 400 of using the current transformer 100 to determine qualities of the conductor signal 222, and to determine and output an operating state of the powered device 300 from the determined qualities of the conductor signal 222, is shown in Figure 4.

In a first step 410, the core 162 and the coil 168 of the current sensor 160 inductively draw a current from the wire 200, and the current in the current signal 170 transmitted from the current sensor 160 is stored in the tuning capacitor 144. The current in the current signal 170 that is inductively drawn from the wire 200, in an embodiment, is used to power the current transformer 100.

The tuning capacitor in existing current transformers is tuned or chosen for optimum efficiency at 50 to 60Hz and is insensitive and inefficient in sensing current at other frequencies. The tuning capacitor 144 in the current transformer 100 according to the present embodiment, by contrast, is tuned or chosen, for example by selection of a capacitor value of the tuning capacitor 144, to have an input frequency response that is optimized for detecting differences in the current signal 170 at higher frequencies described below. In another embodiment, the tuning capacitor 144 can be omitted and, in this embodiment, the omission of the tuning capacitor 144 allows the current transformer 100 to have an input frequency response that is optimized for detecting differences in the current signal 170 at the higher frequencies described below.

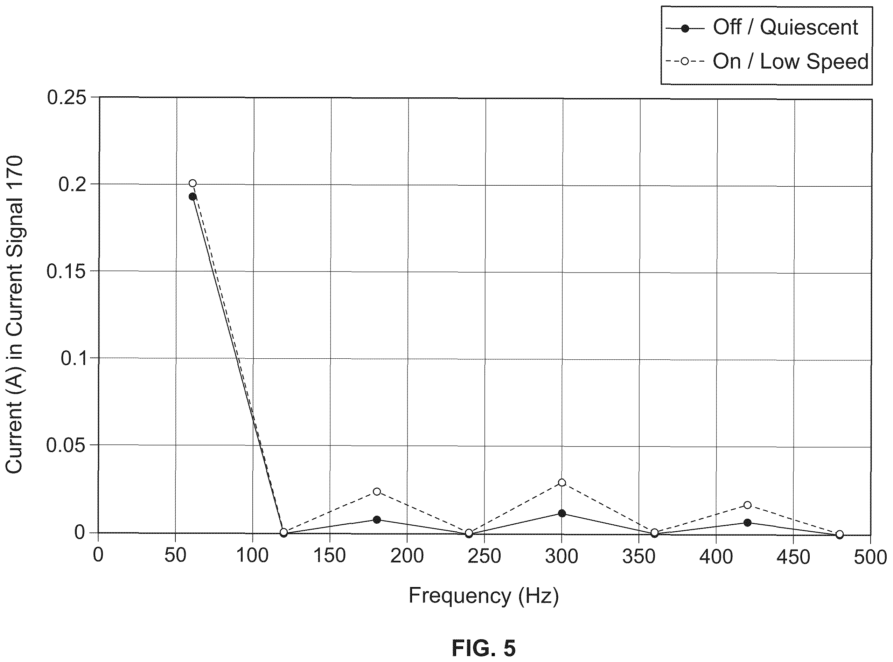

Figure 5 shows a graph of frequency vs. current in the current signal 170 for the conductor signal 222 sent to the powered device 300, where the powered device 300 is an ECM motor. The graph of Figure 5 shows the current at various frequencies for an off state, in which the conductor signal 222 has a quiescent current, and a low speed on state, in which the conductor signal 222 is a 1.1V minimum run speed signal. As shown in Figure 5, for this type of powered device 300, a difference in current between the off and on states in the current signal 170 at 60Hz is small; around 8mA. At higher frequencies, the difference in current in the current signal 170 in the off and on states is greater. At higher frequency harmonics of 60Hz, for example at 180Hz, at 300Hz, and at 420Hz, the difference in current in the current signal 170 in the on and off states is greater than 8mA, for example around 20mA at 180Hz.

The electronic assembly 140, in an embodiment, is tuned to use the current signal 170 of the current in the conductor signal 222 in a frequency range greater than or equal to 100Hz. In an embodiment, the electronic assembly 140 is tuned to use the current signal 170 at one of a plurality of harmonic frequencies of the conductor signal 222, for example the frequencies of 180Hz, 300Hz, or 420Hz described above. Tuning or omitting the tuning capacitor 144 in the electronic assembly 140 allows the electronic assembly 140 to have an input frequency response optimized for detecting the current in the conductor signal 222 in the frequency range greater than or equal to 100Hz; the input frequency response of the electronic assembly 140 is inefficient at detecting the current at a frequency of 50Hz to 60Hz.

In a step 420, the current signal 170 passes through the voltage doubler 146, which rectifies the current signal 170 and multiplies the voltage. The voltage doubler 146 outputs a smoothed, rectified voltage representative of the current signal 170 to the comparator 148.

The comparator 148 also obtains a current threshold 152, shown in Figure 3, in a step 430 of Figure 4. The current threshold 152 is one of a plurality of possible thresholds that can be chosen by a user. During use of the current transformer 100, a user adjusts a position of the manipulated element 182 of the adjustment element 180 to reference one of the markers 126 on the housing 110. The markers 126 or the range defined by the markers 126 corresponds to the possible thresholds; when the manipulated element 182 points to one of the markers 126, the potentiometer 150 sends a signal to the comparator 148 representing the current threshold 152, which is one of the plurality of possible thresholds.

In a step 440, the comparator 148 compares the voltage representative of the current signal 170 received from the voltage doubler 146, with the current signal 170 in the frequency range greater than or equal to 100Hz, to the current threshold 152 received from the potentiometer 150 to determine the operating state of the powered device 300. At a decision point 450, if the current signal 170 is greater than the current threshold 152, the comparator 148 determines that the powered device 300 is in an on state. If the current signal 170 is less than the current threshold 152, the comparator 148 determines that the powered device 300 is in an off state.

If the powered device 300 is determined to be in the on state, in a step 460, the output from the comparator 148 indicates the operating state of the powered device 300 at the indicator 190. By operating the relay 154, the indicator 190 is lit in a first color or pattern when the operating state of the powered device 300 is the on state, such as a green color.

If the powered device 300 is determined to be in the off state, in a step 470, the output from the comparator 148 also indicates the operating state of the powered device 300 at the indicator 190. By operating the relay 154, the indicator 190 is lit in a second color or pattern when the operating state of the powered device 300 is the off state, such as a red color. In other embodiments, the different colors or patterns used to indicate the on state or the off state with the indicator 190 can be any color or pattern capable of being indicated by an LED.

In the current transformer 100, in an embodiment, the indicator 190 is lit both in the off state and in the on state of powered device 300, which simplifies visibility and the user's understanding of the current state. Further, lighting the indicator 190 in both possible states improves performance of the current transformer 100 by balancing power consumption in all states, preventing an issue in which lighting the indicator 190 to indicate a transition from the off state to the on state consumes power and forces the current transformer 100 to inaccurately switch back to the off state.

In the step 480, the comparator 148 can also output the operating state by sending the comparison output to the external connection device 158, which outputs an output signal 194, for example along the external wires 192, that represents the operating state of the powered device 300. In various embodiments, the output signal 194 can be an analog signal or a digital signal according to any of the communication types or protocols of the external connection device 158 described above.

When the comparator 148 outputs the determined operating state of the powered device 300 according to the embodiments described herein, the process 400 can loop back to the beginning, determining the operating state of the powered device 300 for further loops by analyzing the current signal 170 of the current in a frequency range greater than or equal to 100Hz.

In the current transformer 100 according to the present embodiments, the electronic assembly 140 is tuned to a frequency higher than 50 to 60Hz; a frequency greater than 100Hz. At the frequencies greater than 100Hz, the powered device 300, such as an ECM motor, has larger gaps between a quiescent current in an off state and a minimal current in a low run speed state. Thus, the current transformer 100 can use current signals 170 in a higher frequency range to more accurately and reliably indicate the operating state of the powered device 300.

## Claims

1. A current transformer, comprising:
a current sensor sensing a current of a conductor signal transmitted along a conductor and outputting a current signal based on the current; and
an electronic assembly connected to the current sensor and receiving the current signal from the current sensor, the electronic assembly determines an operating state of a powered device to which the conductor feeds the conductor signal based on the current signal, the electronic assembly is tuned to use the current signal of the current in a frequency range greater than or equal to 100Hz to determine the operating state.

2. The current transformer of claim 1, wherein the electronic assembly is tuned to use the current signal of the current at one of a plurality of harmonic frequencies of the conductor signal to determine the operating state.

3. The current transformer of claim 1, wherein the electronic assembly does not have a tuning capacitor for the current signal.

4. The current transformer of claim 1, wherein the electronic assembly has a tuning capacitor that provides an input frequency response optimized for detecting the current in the frequency range greater than or equal to 100Hz, optionally, wherein the input frequency response is inefficient in detecting the current at a frequency of 60Hz.

5. The current transformer of claim 1, wherein the electronic assembly has a comparator comparing the current signal of the current to a current threshold to determine the operating state of the powered device.

6. The current transformer of claim 5, further comprising an adjustment element connected to the electronic assembly, the adjustment element is manipulated to adjust the current threshold.

7. The current transformer of claim 6, further comprising a housing, the current sensor and the electronic assembly are disposed in the housing, the adjustment element is a knob positioned on the housing, optionally, wherein the housing has a plurality of markers on an outer surface of the housing that indicate a plurality of possible thresholds to which the knob can be rotated.

8. The current transformer of claim 6, wherein the adjustment element is connected to a potentiometer of the electronic assembly that outputs the current threshold to the comparator.

9. The current transformer of claim 1, wherein the operating state of the powered device determined is either an off state or an on state of the powered device.

10. The current transformer of claim 9, further comprising an indicator connected to the electronic assembly, the electronic assembly controls the indicator to indicate the operating state of the powered device, optionally, the current transformer further comprising a housing, the current sensor and the electronic assembly are disposed in the housing, the indicator is a light emitting diode extending through the housing, optionally, wherein the light emitting diode is lit in both the on state and the off state.

11. The current transformer of claim 1, wherein the current sensor has a core and a coil disposed around the core, the conductor extends through the core of the current sensor.

12. The current transformer of claim 1, further comprising an external connection device connected to the electronic assembly and outputting the operating state received from the electronic assembly, and/or, wherein the powered device is an electronically commutated motor.

13. A method of determining an operating state of a powered device, comprising:
providing a current transformer having a current sensor and an electronic assembly connected to the current sensor;
sensing a current of a conductor signal transmitted along a conductor to the powered device with the current sensor and outputting a current signal based on the current to the electronic assembly; and
determining an operating state of the powered device based on the current signal, the electronic assembly is tuned to use the current signal of the current in a frequency range greater than or equal to 100Hz to determine the operating state.

14. The method of claim 13, wherein the electronic assembly is tuned to use the current signal of the current at one of a plurality of harmonic frequencies of the conductor signal to determine the operating state.

15. The method of claim 13, wherein the electronic assembly has an input frequency response that is inefficient in detecting the current at a frequency of 60Hz.
